## Europäisches Patentamt
## European Patent Office
## Office européen des brevets

(11) Numéro de publication: **0 098 212**
**B1**

(12) **FASCICULE DE BREVET EUROPEEN**

(45) Date de publication du fascicule du brevet: **20.05.87**

(21) Numéro de dépôt: **83401296.5**

(22) Date de dépôt: **22.06.83**

(51) Int. Cl.⁴: **H 05 K 9/00**

(54) **Structure de blindage pour carte à circuits imprimés.**

(30) Priorité: **25.06.82 FR 8211142**

(43) Date de publication de la demande:
**11.01.84 Bulletin 84/02**

(45) Mention de la délivrance du brevet:
**20.05.87 Bulletin 87/21**

(84) Etats contractants désignés:
**AT BE CH DE GB IT LI LU NL SE**

(56) Documents cités:
**DE-A-2 323 445**
**DE-A-2 613 087**
**DE-A-2 835 676**
**DE-B-1 192 706**
**DE-B-1 286 165**

(73) Titulaire: **SOCIETE ANONYME DE TELECOMMUNICATIONS**
**41, rue Cantagrel**
**F-75624 Paris Cedex 13 (FR)**

(72) Inventeur: **Roger, Christian Michel**
**41, rue Cantagrel**
**F-75624 Paris Cedex 13 (DE)**

(74) Mandataire: **Martinet & Lapoux**
**62, rue des Mathurins**
**F-75008 Paris (FR)**

Courier Press, Leamington Spa, England.

## Description

La présente invention concerne une structure de blindage pour carte à circuits imprimés supportant des groupes de composants électroniques opérant dans le domaine des ondes ultracourtes, du type de celles dont la longueur d'onde est inférieure à quelques mètres. La structure de blindage est généralement partagée en plusieurs compartiments renfermant un groupe de composants qui est isolé du rayonnement électromagnétique émis par les autres groupes.

Plus particulièrement, l'invention concerne une structure de blindage pour carte à circuits imprimés comprenant un capot au-dessus d'une face de la carte, et des cloisons entre la carte et le capot. Chaque cloison comporte des picots insérables dans des trous de la carte et un premier rebord plié à angle droit et appliqué contre le capot.

Une telle structure de blindage est décrite dans les documents allemands DE—A—2 835 676 et DE—B—1 286 165. Les picots de chaque cloison prolongent verticalement la majeure partie de la cloison formant paroi perpendiculaire à la carte et sont soudés à la carte ou rabattus sur la face inférieure de la carte à l'opposé de la cloison.

Un tel montage présente principalement deux inconvénients. D'une part aucune précaution n'est envisagée au niveau de la carte imprimée pour réaliser une continuité électrique afin de fermer complètement le blindage. Par exemple des encoches au-dessus de la carte entre les cloisons et des trous entre cloisons sont prévus ce que ne confère pas un blindage satisfaisant à des fréquences très élevées de l'ordre de 18 GHz. D'autre part, lors du montage de la structure de blindage, les cloisons sont simplement maintenues orthogonales à la carte par l'insertion des picots dans des trous de la carte, ce qui ne stabilise par parfaitement les cloisons sur la carte lors de la pose ultérieure du capot sur les rebords des cloisons. Une telle structure se prête donc mal à un montage par des machines automatiques.

La présente invention a pour but de remédier aux inconvénients précités et en particulier de fournir des cloisons de blindage parfaitement stables sur la carte et conférant un meilleur blindage au niveau de la carte.

A cette fin, l'invention a pour objet une structure de blindage pour carte à circuits imprimés telle que caractérisée dans la revendication 1.

Le second rebord d'une cloison contribue à une meilleure stabilité de la cloison sur la carte lorsque les picots de la cloison sont déjà introduits dans les trous de la carte mais ne sont pas encore soudés. Ces deux opérations sont en effet distinctes notamment lors d'un montage en continu par machines automatiques. En outre, le second rebord de la cloison est entièrement au contact d'une bande conductrice de blindage sur la carte délimitant deux compartiments de blindage, et les picots de la cloison sont soudés à des trous métallisés. Ces trous permettant de relier la bande de blindage à une autre bande de blindage sous la carte elle-même reliée au second rebord d'une autre cloison inférieure délimitant le même compartiment ou de relier la bande de blindage à une surface conductrice recouvrant l'autre face de la carte. La structure de blindage entoure ainsi complètement chaque compartiment analogue à une cage de Faraday.

D'autres caractéristiques avantageuses de la structure de blindage sont énoncées dans les autres revendications annexées.

En particulier, chaque compartiment peut renfermer des composants électroniques implantés sur les deux faces de la carte imprimée, auquel cas la structure est composée d'un capot supérieur, d'un capot inférieur, et de cloisons supérieures et inférieures deux-à-deux sensiblement superposées. Chaque paire de cloisons supérieure et inférieure sont d'une part en contact électrique et éventuellement en contact mécanique afin de réaliser une continuité du blindage. En outre, les cloisons sont disposées de manière à permettre le passage de liaisons de rubans conducteurs d'un compartiment vers un compartiment adjacent à travers des trous métallisés de la carte.

Selon une autre caractéristique, un capot n'est pas simplement posé sur les premiers rebords de la cloison mais y est également fixé par des moyens de fixation détachables, de préférence par machine automatique, du genre ressorts pincettes. De tels moyens de fixation détachables permettent l'accès aisé aux composants électroniques dans les compartiments blindés.

D'autre avantages de l'invention apparaîtront plus clairement à la lecture de la description suivante de plusieurs réalisation de l'invention en référence aux dessins annexés correspondants, dans lesquels:

— la Fig. 1 est une vue en coupe dans un plan perpendiculaire à celui d'une carte imprimée d'une structure de blindage selon une première réalisation;

— la Fig. 2 est une vue en coupe dans un plan perpendiculaire à celui d'une carte imprimée d'une structure de blindage selon une seconde réalisation;

— la Fig. 3 est une vue de face, avant pliage, d'une cloison de la structure de blindage selon la première ou la seconde réalisation;

— la Fig. 4 est une vue en coupe analogue à la Fig. 2 d'une structure de blindage ayant des cloisons en deux éléments assemblés selon une troisième réalisation;

— les Figs. 5a et 5b sont une vue en coupe le long de la ligne V—V de la Fig. 5b et une vue de face avant pliage de l'élément supérieur d'une cloison supérieure ou de l'élément inférieure d'une cloison inférieure de la structure de blindage montrée à la Fig. 4;

— la Fig. 6 est une vue de face, avant pliage, de l'élément inférieur d'une cloison supérieure ou de l'élément supérieur d'une cloison inférieure de la structure de blindage montrée à la Fig. 4;

— les Figs. 7a et 7b sont une vue en coupe le long de la ligne brisée VIIVII de la Fig. 7b et une vue de face d'une cloison de la structure de blindage montrée à la Fig. 4;

— la Fig. 8 est une vue d'une partie de la face supérieure de la carte imprimée au niveau de deux bandes conductrices de blindage superposées sur la carte et au niveau de la liaison de deux conducteurs imprimés de part et d'autre de cloisons supérieurs et inférieure de la structure de blindage montée à la Fig. 2 ou 4;

— la Fig. 9 est une vue de dessus schématique de compartiments blindées formés par les éléments d'une structure de blindage selon l'invention;

— la Fig. 10 est une vue de dessus, avant pliage, d'une bande de fixation d'une cloison à un capot d'une structure de blindage selon l'invention;

— la Fig. 11 est une vue en coupe le long de la ligne X—X de la Fig. 10 de la bande de fixation aprés pliage; et

— les Figs. 12a et 12b sont une vue de côté longitudinale d'un outil de démontage d'une bande de fixation et une vue en coupe transversale le long de la ligne XII—XII de la Fig. 12a de l'outil de démontage au niveau d'une paire de lames flexibles retirées de la bande de fixation.

Dans la description suivante des réalisations illustrées, une carte imprimée 1 désigne une carte imprimé double face 1, par exemple en verre époxy, sur les deux faces de laquelle des composants électroniques discrets ou intégrés (non représentés) sont implantés et ont leurs bornes reliées par des trous métallisés ou non aux rubans conducteurs imprimés de la carte. Comme il est connu, l'implantation des rubans conducteurs et des bornes des composants électroniques est référée à un paramètre de dimensionnement, appelé pas p, dont les multiples entiers définissent les écarts entre rubans conducteurs et bornes des composants suivant deux axes orthogonaux, longitudinal et transversal. Les dimensions des structures de blindage selon l'invention sont ainsi choisies de préférence en fonction du paramètre p ce qui permet une standardisation des éléments de structure de blindage indispensable à une fabrication en grande série, les éléments de structure étant découpés et pliés automatiquement et adaptés à tout circuit à blinder.

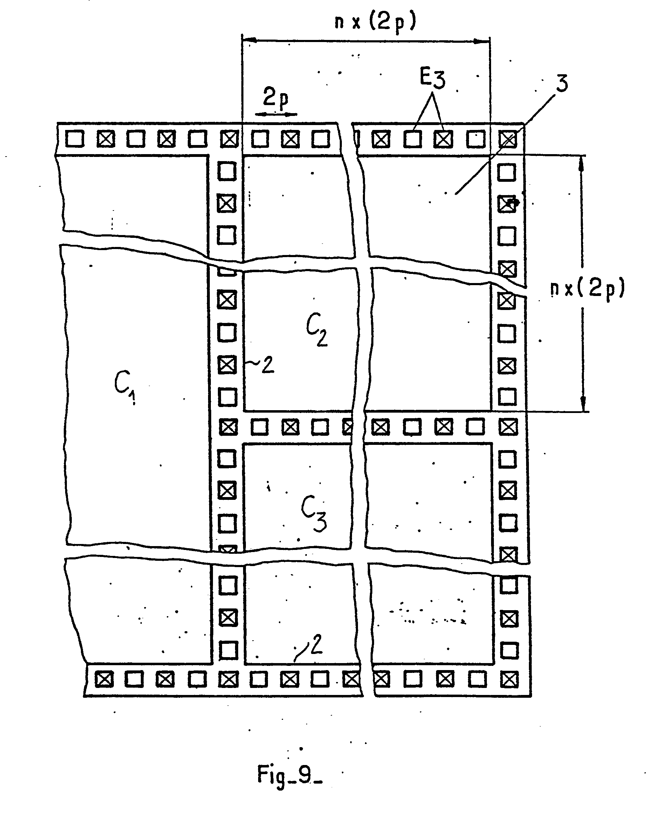

Une structure de blindage selon les réalisations illustrées comportent essentiellement deux types d'éléments, à savoir des cloisons métalliques disposées perpendiculairement à la carte imprimée et des capots métalliques disposés parallèlement à la carte imprimée. Entre un capot de blindage supérieur et un capot de blindage inférier, les cloisons sont réparties par paires, l'une dite cloison supérieure entre le capot supérieur et la face supérieure de la carte imprimée, et l'autre dite cloison inférieure entre la face inférieure de la carte imprimée et le capot inférieur. Pour chaque paire, la cloison supérieure est sensiblement au-dessus de la cloison inférieure et est reliée électriquement à la cloison inférieure, directement et/ou par l'intermédiaire de deux bandes de blindage conductrices superposées sur les deux faces de la carte. De telles bandes conductrices reliées entre elles délimitent des cadres de blindage rectangulaires ou plus généralement polygonaux de part et d'autre desquels les cloisons supérieures et inférieures sont appliquées d'une manière continue. Après la pose des capots de blindage inférieur et supérieur contre les cloisons sont définis des compartiments prismatiques complètement fermés, tels que des cages de Faraday, comme on le verra dans la suite en référence à la Fig. 9. Chaque compartiment renferme ainsi des composants électroniques qui sont implantés sur l'une ou les deux faces de la carte et dont isolés des rayonnements électromagnétiques susceptibles d'être émis par les composants dans les autres compartiments. Les hauteurs des compartiments peuvent être différentes.

Dans la suite on ne décrira en détail chaque structure de blindage qu'au niveau d'une paire de cloisons supérieure et inférieure.

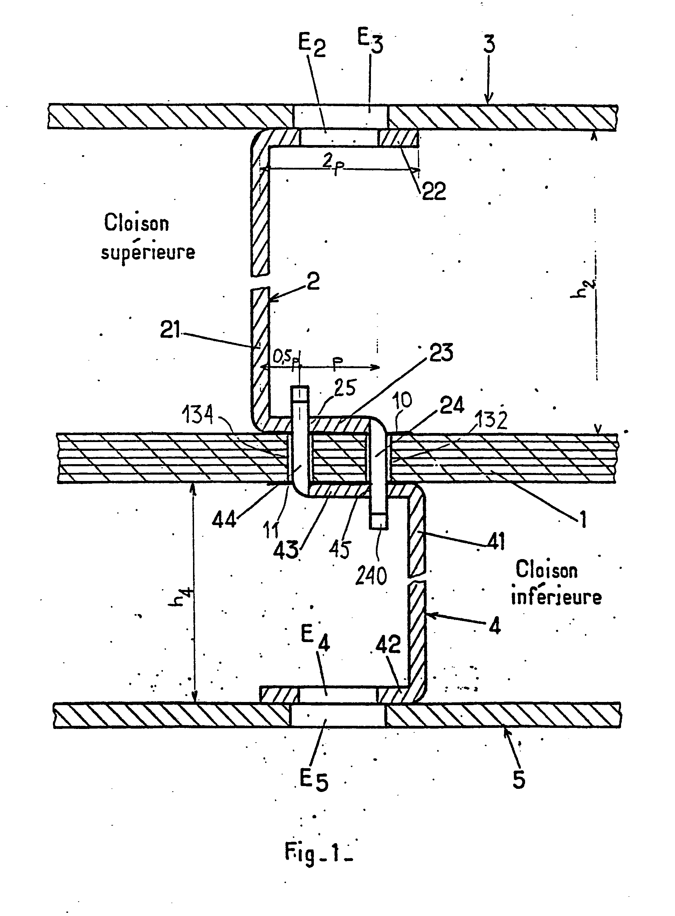

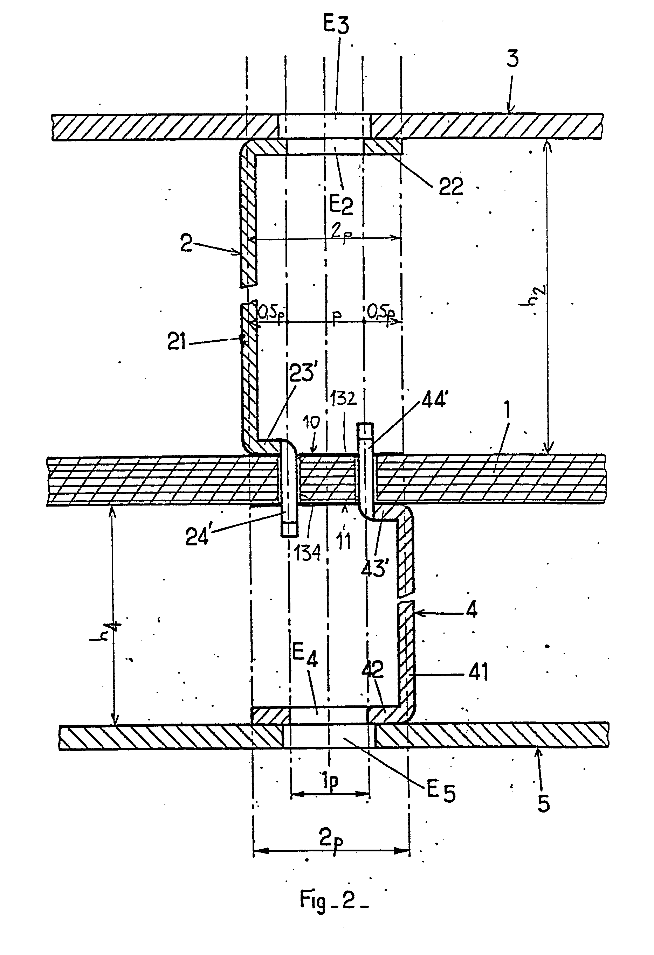

Selon la première réalisation de structure de blindage montrée à la Fig. 1, 2 désigne une cloison supérieure, 3 un capot supérieur, 4 une cloison inférieure sensiblement en dessous de la cloison supérieure, et 5 un capot inférieur.

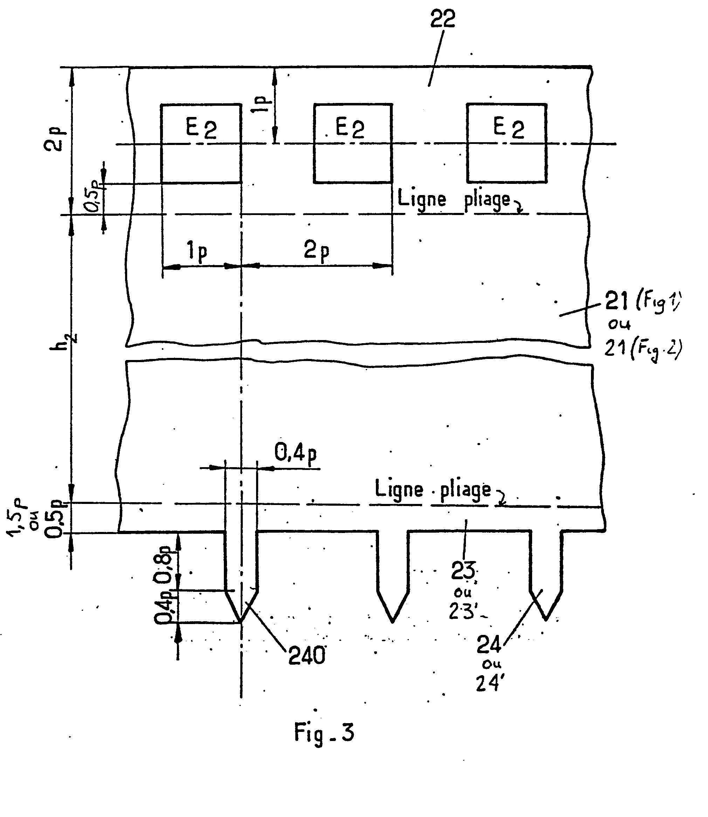

Comme montré aux Figs. 1 et 3, la cloison supérieure 2 est constituée par une plaque métallique quasi-rectangulaire pliée en U dont la majeure partie forme une paroi rigide verticale 21 ayant une hauteur $h_2$. La hauteur $h_2$ est égale à la distance entre le capot supérieur 3 et la carte imprimée 1 et est supérieure à la hauteur maximum des composants électroniques implantés sur la face supérieure de la carte imprimée. Les bords horizontaux de la cloison 2 sont formés par des rebords supérieur 22 et inférieur 23 pliés à 90° par rapport à la paroi 21. Le rebord supérieur 22 a une largeur égale à 2p et supporte le capot supérieur 3. Le rebord inférieur 23 a une largeur égale à 1,5 p et est plaquée contre une bande conductrice de blindage 10 sur la face supérieure de la carte imprimé 1.

Une bande conductrice de blindage 11 est également prévue sur la face inférieure de la carte imprimée et en dessous de la bande 11. A travers la carte imprimée 1 sont percées deux séries parallèles de trous métallisés 132 et 134 de diamètre 0,5p de part et d'autre des axes longitudinaux de symétrie des bandes 10 et 11 et à une distance égale à p (ou 2p). Les trous 132 et 134 relient ainsi électriquement les bandes de blindage 10 et 11 dont la largeur est égale à 2p.

Le rebord inférieur 23 est prolongé partiellement en direction transversale de picots parallèles 24 à bout pointu 240. Les picots ont été pliés à 90° vers le bas par rapport au rebord 23 et sont ainsi parallèles à la paroi verticale 21. Les picots 24 ont une section rectangulaire ayant une largeur de l'ordre de 0,4p, sensiblement inférieure au diamètre des trous 132 et 134, et une longueur de 1,2p nettement supérieure à l'épaisseur de la carte imprimée 1 de l'ordre de 0,75p. Les picots 24 sont régulièrement espacés entre eux de 2p, et sont enfichés respectivement dans les trous 132 de sorte que le rebord 23 s'appuie sur les trois quarts de la bande de blindage supérieure 10, à gauche dans la Fig. 1.

La cloison inférieure 4 a une forme analogue à celle de la cloison supérieure 2, et une position déduite de celle de la cloison 2 par un retournement à 180° autour de l'horizontale. La cloison inférieure 4 comprend ainsi une paroi rigide verticale 41 ayant une hauteur $h_4$ qui peut être différente de $h_2$, ainsi qu'un rebord inférieur horizontal 42, un rebord supérieur horizontal 43 et des picots verticaux 44 dont les dimensions sont respectivement identiques à celles des portions 22, 23 et 24 de la cloison supérieure 2. Comme on le voit à la Fig. 2, les parois 21 et 41 sont disposées parallèlement à une distance égale à 2p et le rebord supérieur 22 de la cloison supérieure 22 est aligné juste au-dessus du rebord inférieur 42 de la cloison inférieure 4 qui s'appuie contre le capot inférieur 5. Le rebord supérieur 43 de la cloison inférieure 4 supporte la carte imprimée 1. Les trois quarts de largeur de la bande de blindage inférieure 11-percés des trous 132 at à droite dans la Fig. 1—sont appliqués sur le rebord 43.

Les picots 44 s'enfichent dans les trous métallisés correspondants 134 se trouvant sous le rebord inférieur 23 de la cloison supérieure 2. L'extrémité pointue des picots facilite l'introduction des picots dans les trous. Cependant, conjointement aux enfichages des picots 24 et 44 dans les trous respectifs 132 et 134 de la carte imprimée, les picots 24 traversent des trous verticaux 45 ménagés dans le rebord 43 de l'autre cloison 4 et centrés respectivement sous les 132, et les picots 44 traversent des trous verticaux 25 ménagés dans le rebord 23 de l'autre cloison 2. Les trous 25 et 45 ont une section de préférence rectangulaire analogue à celle des picots 24 et 44. Le montage solidarise ainsi intimement les cloisons 2 et 4 dont les rebords 23 et 43 entretoisent la carte imprimée 1, et consolide la structure de blindage.

La structure selon une seconde réalisation montrée à la Fig. 2 se distingue de celle montrée à la Fig. 1 par le fait que les rebords 23 et 43 sont remplacés par des rebords 23' et 43' ayant une largeur égale à 0,5p. Dans ce cas, les picots 24' prolongeant à la verticale le rebord 23' de la cloison supérieure 2 s'enfichent seulement dans les trous 134 de la carte imprimée 1—à gauche dans les Figs. 1 et 2—et ne sont plus au contact direct de l'autre cloison 4. De même, les picots 44' prolongeant à la verticale le rebord 43' de la cloison inférieure 4 s'enfichent seulement dans les trous 132 de la carte imprimée 1—à droite dans les Figs. 1 et 2—et ne sont plus au contact direct de l'autre cloison 2.

Comme on le voit dans les Figs. 1 à 3, des orifices $E_2$ et $E_4$ à section carrée p×p sont pratiqués respectivement le long des axes longitudinaux médians du rebord 22 de la cloison supérieure 2 et du rebord 42 de la cloison inférieure 2. Les orifices $E_2$ et $E_4$ sont superposés deux à deux verticalement. Dans chaque rebord 22, 42, les orifices carrés $E_2$, $E_4$ sont prévus à des distances de 2p les uns des autres et ont chacun un côté—par exemple à droite dans la Fig. 3—colinéaire à l'axe médian d'un picot 24 ou 24' 44 ou 44' avant pliage de la cloison comme montré à la Fig. 3. Des orifices $E_3$ dans le capot supérieur 3 sont respectivement centrés au-dessus des orifices $E_2$ et, de même, des orifices $E_5$ dans le capot inférieur 5 sont respectivement centrés au-dessous des orifices $E_4$. Les orifices $E_4$ et $E_5$ ont des sections carrées sensiblement supérieure à p×p. Les orifices $E_2$, $E_3$, $E_4$ et $E_5$ sont destinés à solidariser les cloisons 2 et 4 aux capots 3 et 4 au moyen de bande de fixation amovible comme on le verra dans la suite.

Par contre, la liaison des cloisons 2 et 4 avec la carte imprimée est réalisée par soudage. Les cloisons 2 et 4 sont par exemple en un alliage soudable, tel qu'Arcap ou laiton étamé. Le soudage est réalisé principalement entre les picots 24 ou 44', et 44 ou 24' et les trous métallisés respectifs les contenant 132 et 134 afin de réaliser un blindage continu entre les cloisons 2 et 4 par l'intermédiaire des rebords 23 ou 23' et 43 ou 43' et des bandes de blindage 10 et 11. Le soudage est réalisé de préférence par deux passages à la vague d'étain respectivement du côte, des faces supérieure et inférieure de la carte imprimée 1 avant montage des capots 3 et 5. Bien que les orifices $E_2$ et $E_4$ soient sensiblement à la verticale des trous 132 et 134, il peut arriver que la soudure ne remplliss pas complètement les espaces entre les picots et les parois des trous métallisés ce qui réduit alors le blindage. Cet inconvénient est en partie dû à la présence des rebords 22 et 42 faisant sensiblement obstacle au passage des vagues d'étain vers les trous 132 et 134.

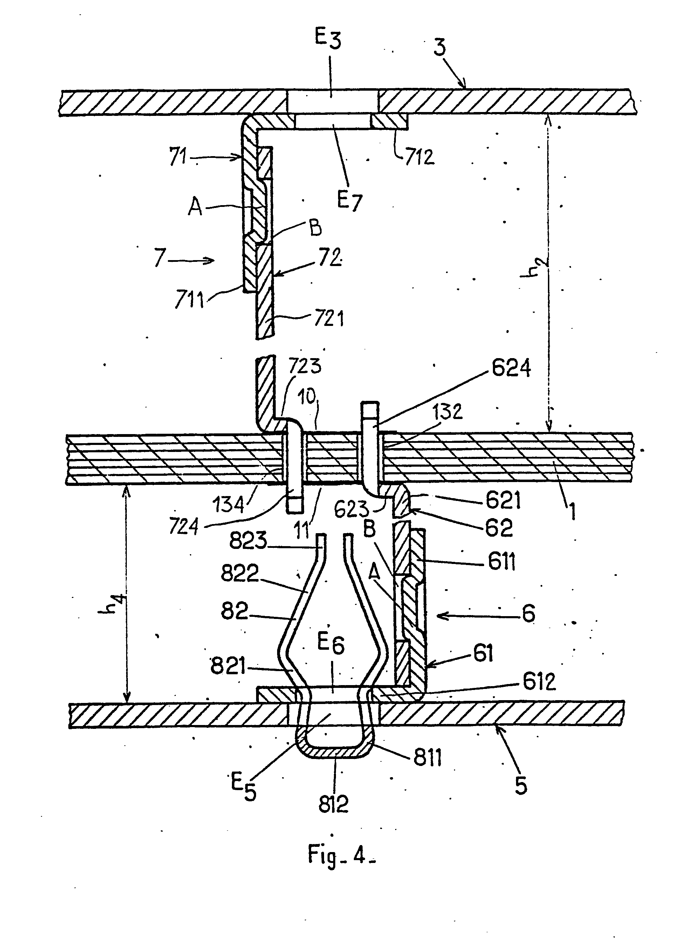

La troisième réalisation de structure de blindage montrée à la Fig. 4 remédie à cet inconvénient. La structure de blindage montrée à la Fig. 4 est en effet composée de cloisons inférieures 6 et supérieures 7 constituées chacune de deux éléments distincts assemblés 61, 62 et 71, 72. Les liaisons des cloisons 6 et 7 à la carte imprimée 1 sont du type de celles illustrées à la Fig. 2, bien que des cloisons avec des liaisons à la carte imprimée telles que celles montrées à la Fig. 1 puissent être prévues chacune en deux éléments assemblés comme décrit ci-après.

En référence à la Fig. 4 ne sera décrit que la cloison inférieure 6 composée d'un élément inférieur 61 et d'un élément supérieur 62. L'élément inférieur 61 est destiné à être appliqué sur le capot inférieur 5 et a une forme analogue à l'élément supérieur 71 de la cloison supérieur 7 destiné à être appliqué sous le capot supérieur 3. De même l'élément supérieur 62 est destiné à être appliqué contre la face inférieure de la carte imprimée 1 et à être relié à celle-ci par des picots et a une forme analogue à l'élément inférieur 72 de la cloison supérieure 7 destiné à être appliqué sur la face supérieure de la carte imprimée 1 et à être relié à celle-ci par des picots.

La cloison 6 diffère dont de la cloison inférieure 4 montrée à la Fig. 2 par le fait que la paroi 41 est remplacée par l'assemblage de deux portions verticales 611 et 621 des éléments de cloison 61 et 62 qui sont appliquées l'une contre l'autre. Ainsi on retrouve dans la Fig. 4, un rebord inférieur 612 à orifices $E_6$ qui est analogue au rebord 42 et qui prolonge par l'intermédiaire d'un coude à 90° la portion verticale 611 pour s'appuyer contre le capot 5, ainsi qu'un rebord supérieur horizontal 623 qui est analogue au rebord 43' et qui prolonge par l'intermédiaure d'un coude à 90° la portion verticale 621 pour s'appuyer contre la bande de blindage 11, et des picots verticaux 624 qui sont identiques aux picots 44' et qui prolongent par l'intermédiaire d'un coude à 90° le rebord 623. La hauteur de la portion verticale 621 est sensiblement de l'ordre de la différence de la hauteur $h_4$ et de l'épaisseur des éléments 61, 62, tandis que la hauteur de la portion verticale 612 est de l'ordre de 2p.

La fixation des picots 624 dans les trous métallisés 132 s'effectue également par passage à la vague d'étain. Cependant, contrairement à la première ou à la seconde relisation, aucun rebord tel que 42 n'entrave la pénétration directe de la soudure dans les trous 132, car l'élément 61 est fixé à l'élément 62 après le passage de la vague d'étain.

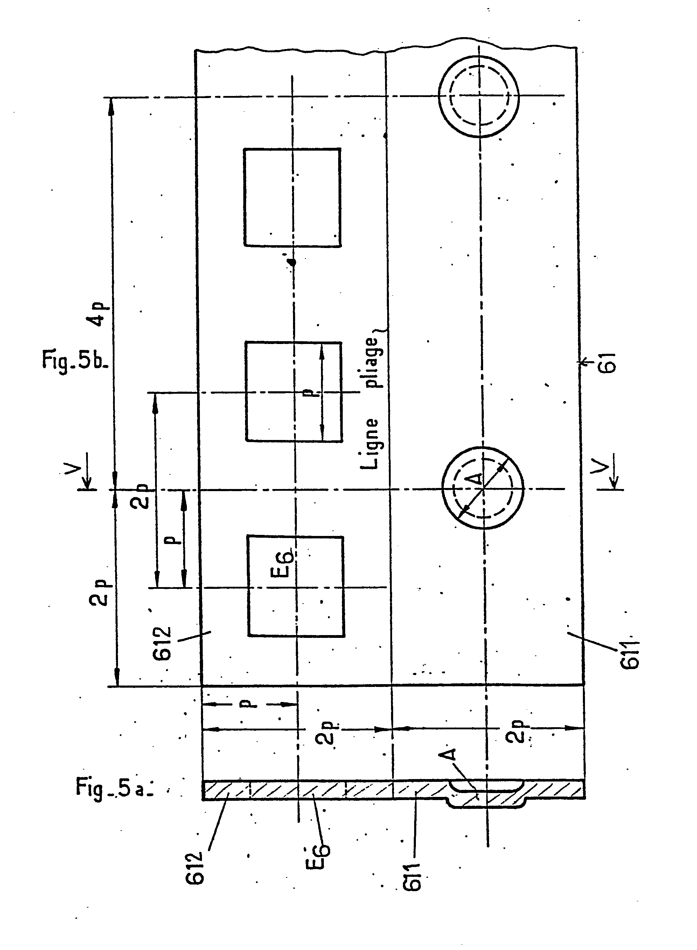

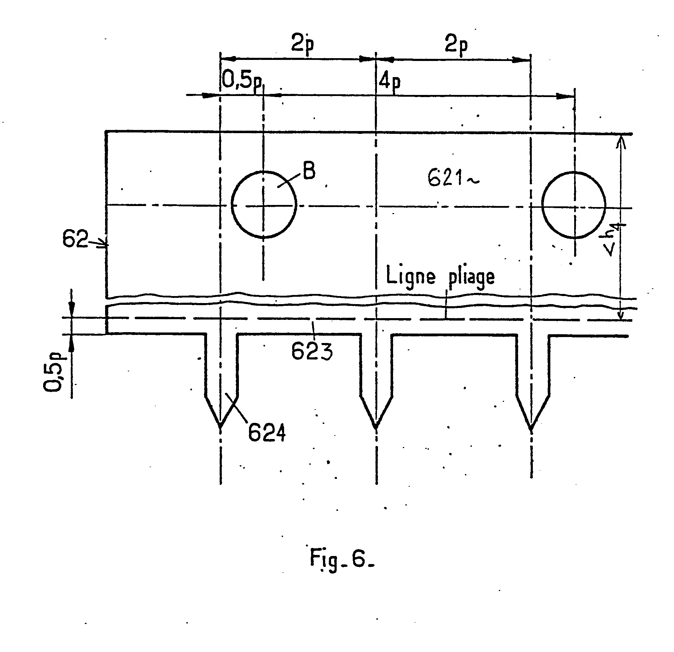

Pour la fixation des éléments 61 et 62, des bossages de centrage A sont prévus sur une face de l'une des portions verticales telle que 61 et des logements de positionnement B complémentaires aux bossages sont prévus sur la face de l'autre portion verticale telle que 62 respectivement en regard des bossages A. Les bossages A sont obtenus par emboutissage avant pliage de l'élément 61, comme montré aux Figs. 5a et 5b. Les logements B peuvent être obtenus par emboutissage pour former des lamages ou par perçage de trous dans l'élément 62 avant pliage, commen montré aux Figs. 4, 6 et 7. Les bossages A et les logements B sont alignés horizontalement sur l'axe médian longitudinal de la portion 61, sont régulièrement espacés de 4p, et sont prévus entre paires successives d'évidements $E_6$.

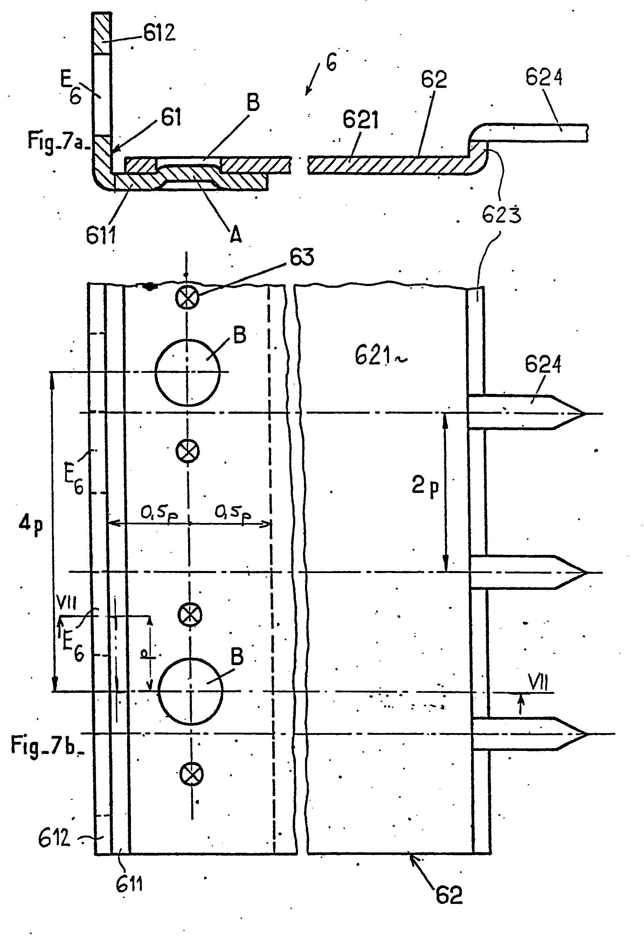

Les bossages A et les logements B sont de préférence circulaires. Après fixation de l'élément 62 à la carte imprimée 1, les portions 611 et 621 formant paròi verticale sont assemblées en appliquant les bossages A dans les logements B. Ceci positionne automatiquement l'élément 61 par rapport à l'élément 62 et, en particulier, les orifices $E_6$ par rapport aux picots 624. Puis, la portion 61 est solidarisée à la portion 62 par des points de soudures, tels que 63 montrés à la Fig. 7b, par exemple au nombre de deux entre deux logements successifs B. Selon la troisième réalisation, les éléments 62 et 72 sont en matériau soudable, par exemple en Arcap ou en laiton étamé, afin de permettre un soudage à la vague d'étain des picots à la carte imprimée. Par contre, les éléments 61 et 71 peuvent être simplement en acier inoxydable.

On notera que dans la Fig. 4, les parties de la cloison supérieure 7 repérées par les signes de référence 711, 712, 721, 723 et 724 sont analogues aux parties 611, 612, 621, 623 et 624 de la cloison inférieure 6, respectivement.

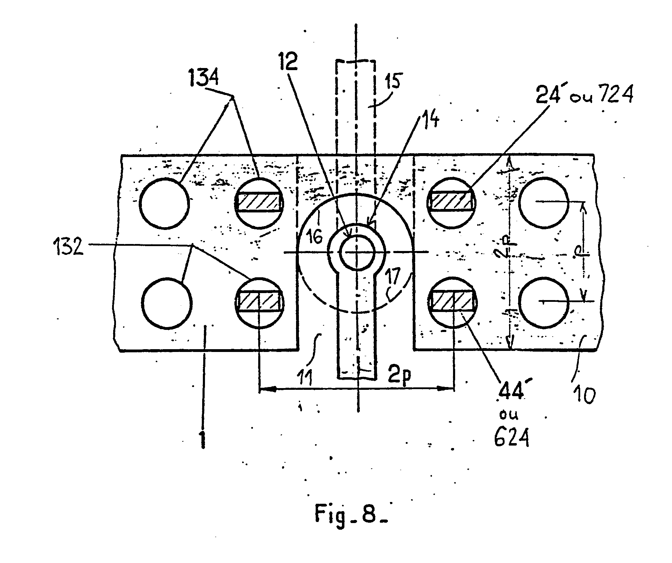

La Fig. 8 représente une vue partielle de la face supérieure de la carte imprimée 1 après soudage de picots tels que 44' et 24' des cloisons selon la second réalisation. Dans la Fig. 8, on a également représenté la liaison d'un ruban conducteur 14 et d'un ruban conducteur 15 provenant respectivement des circuits imprimés partagés par les cloisons 2 et 4. Le ruban conducteur 14 du côté de la cloison inférieure 4 est sur la face supérieure de la carte 1, et le conducteur 15 du côté de la cloison supérieure 2 est sur la face inférieure de la carte 1. Les rubans conducteurs 14 et 15 sont perpendiculaires aux cloisons et peuvent ainsi avoid leurs extrémités reliées par un trou métallisé 12 qui est pratiqué dans la carte 1 à mi-distance entre les cloisons 2 et 4. Les extrémités des rubans conducteurs 14 et 15 sont isolées respectivement des bandes de blindage 10 et 11 grâce à des dégagements à fond semi-circulaire 16 et 17 ménagés dans les bandes 10 et 11 autour du trou 12. Lors du passage à la vague d'étain, le trou 12 et tous les trous 132 et 134, y compris ceux ne recevant pas de picots, peuvent être remplis de soudure.

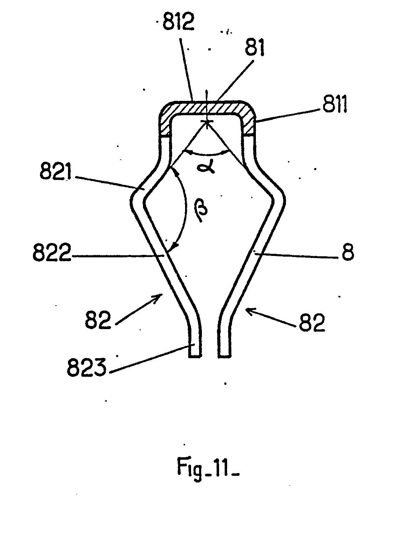

En se référant maintenant aux Figs. 4, 10 et 11, on décrit une bande de fixation détachable 8 propre à assembler un rebord inférieur 42 ou 612 d'une cloison inférieure 4 ou 6 au capot inférieur 5, ou à assembler un rebord supérieur 22 ou 712 d'une cloison supérieure 2 ou 7 au capot supérieur 3. Dans la suite, on se référera par exemple à l'assemblage du rebord 612 au capot 5, comme montré à la Fig. 4.

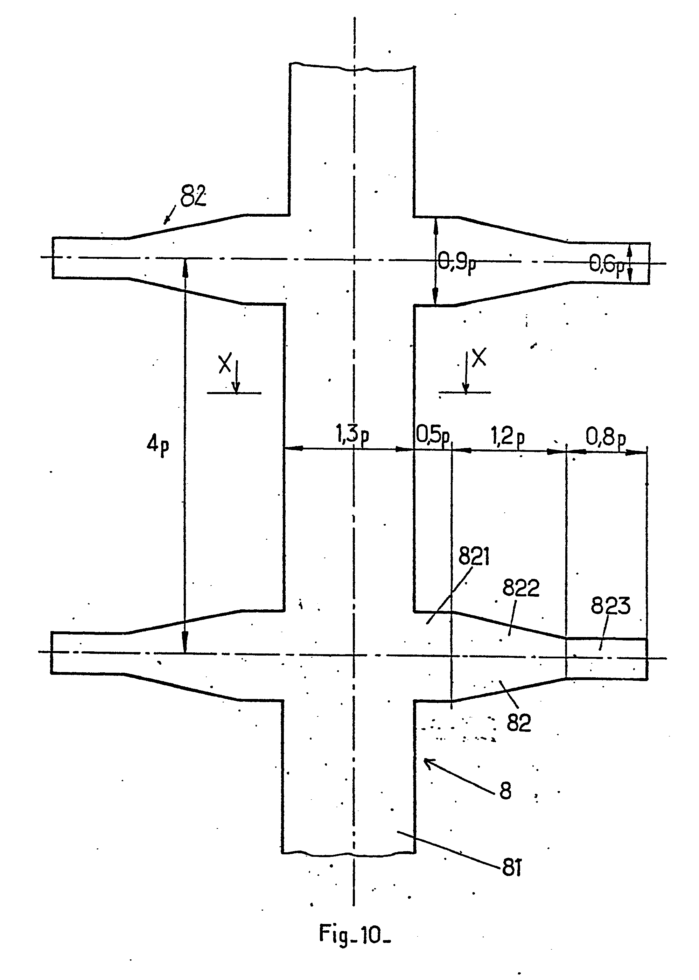

La bande de fixation 8 est obtenue par découpage d'une plaque métallique, par exemple èn acier inoxydable, suivant un contour tel que montré à la Fig. 10. La bande 8 possède une portion rectangulaire longiligne 81 et des paires de lames flexibles 82 régulièrement espacées de 4p et en saillie le long de la portion 81. Les deux lames 82 d'une paire sont symétriques par rapport au grand axe de la portion rectangulaire central 81. Deux paires de lames ont été représentées dans la Fig. 10, bien qu'en pratique la bande de fixation 8 comporte un grand nombre de paires de lames sensiblement égal à la moitié du nombre d'orifice $E_6$ de la cloison considérée 6.

A partir de la portion centrale 81 ayant une largeur typiquement de 1,3p, chaque lame 82 comporte trois portions successives 821, 822 et 823. La première portion 821 au voisinage de la portion centrale 81 est rectangulaire et typiquement a une largeur égale à 0.9p et une hauteur égale à 0,5p. La seconde portion 822 a une section en trapèze isocèle dont la grande base est adjacente à la portion 821. La hauteur de la portion 822 est typiquement égale à 1,2p. La troisième portion 823 est rectangulaire et a une largeur typiquement de 0,6p égale à celle de la petite base de la portion 822, et une hauteur typiquement de 0,8p. La lame 82 se présente ainsi comme une lame épointée, la portion 823 n'étant pas indispensable.

La bande de fixation 8 telle que découpée selon la Fig. 10 est soumise ensuite à plusieurs opérations de pliage, afin que sa section soit transversale conformée comme montrée à la Fig. 1 La portion rectangulaire centrale 81 est pliée le long de ses deux chants longitudinaux sensiblement à 90° pour former une gouttière 812 profilée en U à deux petites ailes longitudinales 311, ecartées d'une distance sensiblement inférieure à p. Chaque paire de lames 82 forme ainsi avec la gouttière une attache à section en U ayant deux branches flexibles. Puis chaque lame 82 subit un premier pliage vers l'extérieur de la gouttière, sensiblement au-dessus des bords 811 de sorte que les deux portions 821 d'une paire de lames en vis-à-vis forment un angle α de 90°. Puis un second pliage au niveau de la grande base de la portion trapézoïdale 822 rabat les portions 822 et 823 vers l'intérieur de la gouttière 812 de sorte que la portion 822 de chaque lame forme un angle β de l'ordre de 100° avec la portion 821. La portion 823 de chaque lame éventuellement présente subit ensuite un pliage vers l'extérieur pour devenir parallèle aux ailes 811 de la gouttière 812.

Chaque paire de lames flexibles 82 est susceptible après pliage de jouer le rôle de ressort pincette pour maintenir en contact rigide un capot tel que 5 avec le rebord tel que 612 d'une cloison. Comme montré à la Fig. 4, chaque paire de lames flexibles 82 est introduite dans une paire d'orifices superposés $E_5$ et $E_6$ du capot 5 et du rebord 612, à raison d'une paire de lames toutes les deux paires d'orifices $E_5$ et $E_6$. La distance entre les extrémités 823 des deux lames 82 étant nettement plus faible que la largeur des orifices carrés $E_5$ et $E_6$ et la distance des coudes d'angle β entre les portions 821 et 822 étant cependant plus grande que la largeur des orifices $E_5$ et $E_6$, les lames 82 se rapprochent lors du passage desdits coudes dans les orifices $E_5$ et $E_6$ puis s'écartent par leur flexion propre jusqu'à ce que les ailes 811 de la gouttière viennent buter contre la face inférieure externe du capot 5. Lors de l'écartement des lames 82, les portions 821 exercent une pression contre le contour externe de l'orifice $E_6$ ce que enserre le rebord 612 et le capot 5 entre les portions 821 et les ailes 811 de la gouttière. La cloison 6 est ainsi fixée solidement au capot 5.

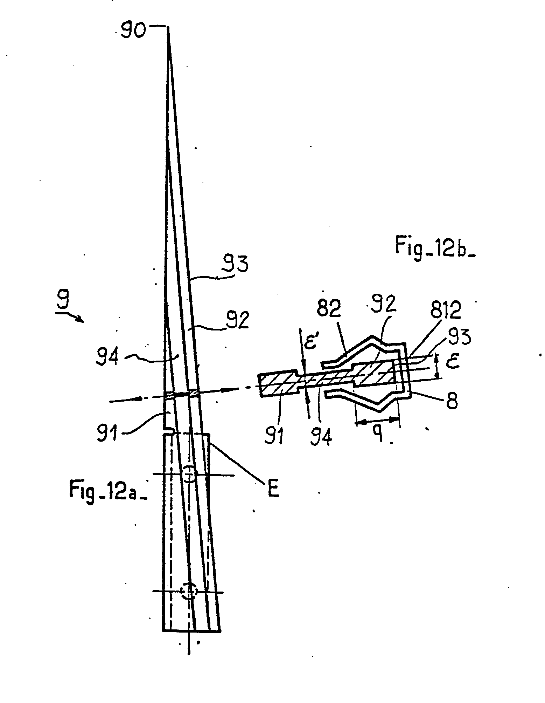

Inversement, une telle bande de fixation 8 est aisément démontable en utilisant un outil de démontage du genre de celui 9 montré à la Fig. 12a. L'outil 9 se présente sous la forme d'une pointe à section longitudinale en triangle rectangle dont le petit angle aigu forme le sommet 90 de la pointe. La section transversale de l'outil 9, comme montrée à la Fig. 12b, est profilée en I dont les ailes 91 et 92 sont parallèles à l'hypothénuse 93 de la section longitudinale triangulaire. L'épaisseur ε des ailes 91 et 92 est nettement inférieure à la largeur de la gouttière 812 de la bande de fixation 8 tandis que l'épaisseur ε' de la jambe 94 du I est sensiblement égale à l'écart entre les portions 823 de deux lames parallèles 82. La hauteur q de l'aile 92 est sensiblement inférieure à la hauteur des portions 821 et 822 des lames 82 tandis que la hauteur de la jambe 94 du I est plus grande que la hauteur des portions 823. Une poignée convenable E est fixée à l'extrémité de l'outil 9, du côté de l'angle droit de la section triangulaire.

Pour retirer une bande de fixation 8 et donc désolidariser un capot tel que 5 d'un rebord de cloison tel que 612, la pointe 90 de l'outil 9 est introduite entre la face externe du capot 5 et le fond de la gouttière 812. La grand côté de la section triangulaire formée en partie par l'aile 91 du I est appliqué contre la face externe du capot 5 le long de l'axe commun des orifices $E_5$, et l'hypothéuse 93 bute contre une extrémité du fond de la gouttière 812. L'outil 9 est alors glissé dans la gouttière 812 tout en s'appuyant contre le capot 5. Le glissement de l'outil 9 tire progressivement la bande de fixation 8 vers le bas ce que entraîne le passage progressif des paires de lames 82 à travers les paires d'orifices $E_5$ et $E_6$. Au fur et à mesure du glissement de l'outil 9, l'aile inférieure 92 pénètre entre les portions 821 et 822 des lames puis la jambe 94 de l'outil s'intercale entre les portions 823 des lames lors du retrait complet de celles-ci. Cependent, les lames 82 sont encore supportées par l'outil 9 grâce à l'emprisonnement et le pincement de la jambe 94 par les portions 823.

On notera que toutes les opérations de montage des cloisons ou des éléments de cloisons et de montage et de démontage des capots et des bandes de fixation peuvent être réalisées en continu par des machines automatiques.

A la Fig. 9 on a représenté schématiquement des compartiments blindés tels que $C_1$, $C_2$ et $C_3$ délimités sur la face supérieure de la carte 1 par des cloisons supérieures 2 (ou 7) selon l'invention et fermés par le capot supérieur 3. On voit que les orifices $E_3$ alignés sur le dessus des rebords supérieurs des cloisons sont distants de 2p. Un orifice $E_3$ sur deux, tel que ceux repérés par une croix dans la Fig. 9, est destiné à recevoir une paire de lames flexibles 82 d'une bande de fixation 8. Chaque compartiment peut être ainsi parallélépipédique avec une longueur et une largeur égales à des nombres tels que n × 2p où n est un entier. Plus généralement le contour horizontal des compartiments formant cages de Faraday peut être polygonal et avoir des dimensions choisies en fonction de l'implantation des composants du circuit respectif à blinder.

Bien que l'invention ait été décrite suivant des réalisations préférées de structure de blindage, d'autres modifications entrant dans le cadre de l'objet des revendications annexées peuvent être envisagées. La structure de blindage ne peut comporter des cloisons que du côté de la face de la carte imprimée supportant des composants. Dans ce cas, l'autre face de la carte imprimée est complémentairement métallisée et joue le rôle du capot de blindage 5 maintenant supprimé. Les bandes de fixation 8 peuvent être remplacées par des ressorts pincettes individuels conformés d'une manière analogue aux paires de lames flexibles 82. Par ailleurs les dimensions relatives au pas p peuvent être modifiées.

**Revendications**

1. Structure de blindage pour carte à circuits imprimés comprenant un premier capot (3) au-dessus d'une première face de la carte (1), et des premières cloisons (2) entre la carte et le premier capot, chaque première cloison (2) comportant des picots (24) insérables dans des premiers trous (132) de la carte (1) et un premier rebord (22) plié à angle droit et appliqué contre le premier capot (3), caractérisée en ce que chaque première cloison (2) comporte un second rebord (23) plié à angle droit et appliqué contre une première bande conductrice de blindage (10) sur la première face de la carte (1), et en ce que les picots (24) de chaque première cloison prolongent le second rebord (23) et sont pliés à angle droit par rapport au second rebord pour pénétrer dans des premiers trous métallisés (132) de la carte.

2. Structure de blindage conforme à la revendication 1, caractérisée en ce que les premier et second rebords (22), 23) sont en vis-à-vis.

3. Structure de blindage conforme à la revendication 1 ou 2, caractérisée en ce que chaque première cloison (7) est composée de deux éléments distincts (71, 72), un premier élément (71) comportant le premier rebord (712) et une portion (711) formant paroi et un second élément (72) comportant le second rebord (723), les picots (724) et une portion (721) formant paroi, et en ce que les portions formant paroi (711, 721) sont maintenues l'une contre l'autre par des moyens de fixation, tels que points de soudure (63), appliqués après fixation des picots (724) dans les trous de la carte (1) et avant montage du premier capot (3) sur les premiers rebords (712).

4. Structure de blindage conforme à la revendication 3, caractérisée en ce que les portions (711, 721) formant paroi des deux éléments (71, 72) de chaque première cloison (7) comportent des moyens de centrage et de positionnement coopérants, tels que bossages de centrage (A) sur l'un (71) des deux éléments et logements de positionnement (B) dans l'autre élément (72).

5. Structure de blindage conforme à l'une quelconque des revendications 1 à 4, caractérisée en ce qu'elle comprend un second capot (5) en dessous de la seconde face de la carte (1) et des secondes cloisons (4; 6) entre la carte imprimée et le second capot, chaque second cloison étant respectivement sensiblement en dessous d'une première cloison (2; 7) ayant une forme analogue aux premières cloisons et une position déduite de celle de la première cloison associée par un retournement à 180° autour d'un axe parallèle à la carte (1), et en ce que le second rebord (43; 623) de chaque second cloison (4; 6) est appliqué contre une seconde bande conductrice de blindage (11) sur la seconde face de la carte (1) et sous-jacente à la première bande de blindage (10) contre laquelle est appliqué le second rebord (23; 723) de la première cloison associée (2; 7) les picots (24, 44; 624, 724) des première et seconde cloisons associées pénétrant dans des trous métallisés (132, 134) reliant les deux bandes de blindage (10, 11).

6. Structure de blindage conforme à la revendication 5, caractérisée en ce que les rebords (22, 23, 42, 43; 712, 723, 623, 612) des première et seconde cloisons associées (2,4; 7,6) sont superposés entre les parties formant paroi (21, 41; 711, 721, 612, 621) desdites cloisons associées.

7. Structure de blindage conforme à la revendication 6, caractérisée en ce que les picots (24, 44) de chacune de première et seconde cloisons associées (2,4) pénétrent dans des trous (45, 25) du second rebord (43, 23) de l'autre cloison (4, 2).

8. Structure de blindage conforme à l'une quelconque des revendications 1 à 7, caractérisée en ce que le premier rebord (22, 42, 712, 612) de chaque cloison (2, 4, 7, 6) est fixé au capot correspondant (3, 5) par des moyens de fixation détachables (8).

9. Structure de blindage conforme à la revendication 8, caractérisée en ce que les moyens de fixation sont constitués par des ressorts pincettes (8—82) ayant chacun deux branches flexibles (821—822) traversant deux orifices ($E_3$, $E_2$, $E_7$, $E_5$, $E_4$, $E_6$) du capot (3; 5) et du premier rebord de cloison (22, 712; 42, 612), et un fond (812) appliqué contre la face externe du capot (3; 5), et en ce que les branches flexibles (821—822) de chaque ressort pincette (8—82) ont des coudes (entre 811 et 821) s'appliquant par leur flexion propre contre le bord de l'orifice ($E_2$, $E_7$; $E_4$, $E_6$) premier rebord de cloison (22, 712; 42, 612).

10. Structure de blindage conforme à la revendication 9, caractérisée en ce que les ressorts pincettes (8—82) pour la fixation d'une cloison (2, 4, 7, 6) sont conformés en une bande de fixation monobloc (8) dont le fond (812) est une bande rectangulaire (81) commune aux fonds (811—812) des ressorts pincettes (8—82).

11. Structure de blindage conforme à la revendication 10 ou 11, caractérisée en ce que le fond (812) de chaque ressort pincette (8—82) est en forme de U et a des bords (811) appliqués contre le capot (3, 5).

12. Structure de blindage conforme à l'une quelconque des revendications 1 à 11, caractérisée en ce que les picots (24, 44, 624, 724) des cloisons (2, 4, 6, 7) sont soudés dans les trous métallisés (132, 134) de la carte (1) de préférence par passage à la vague d'étain.

13. Structure conforme à l'une quelconque des revendications 1 à 12, caractérisée en ce que des dimensions des cloisons (2, 4, 6, 7) telles que les écarts entre picots (24, 44, 624, 724) de chaque cloison et les dimensions des rebords (22, 23, 42, 43, 612, 623, 712, 723) sont choisis comme des multiples entiers du pas (p) entre rubans conducteurs (14, 15) de la carte (1).

14. Outil de démontage de ressorts pincettes pour la fixation d'une cloison à un capot conformés à la revendication 11, caractérisé en ce qu'il est conformé en pointe (9) à section longitudinale en triangle rectangle dont le grand côté (91) est destiné à être appliqué contre la face externe du capot (3, 5) et dont l'hypothénuse (93) est destinée à glisser contre les fonds (812) des ressorts pincettes (8—82) afin de les retirer des orifices superposés ($E_3$, $E_2$, $E_7$; $E_5$, $E_4$, $E_6$) du capot

13     0 098 212     14

(3, 5) et du premier rebord (22, 712; 42, 612) de la cloison (2, 7; 4, 6).

15. Outil conforme à la revendication 14, caractérisé en ce que sa section transversale est profilée en I avec des ailes (91, 92) parallèles à l'hypothénuse (93).

**Patentansprüche**

1. Abschirmstruktur für Leiterplatten, bestehend aus einer ersten Abdeckung (3) über einer ersten Seite der Leiterplatte (1) und ersten Zwischenwänden (2) zwischen der Leiterplatte und der ersten Abdeckung, wobei jede erste Zwischenwand (2) Keile (24) hat, die sich in die ersten Löcher (132) der Leiterplatte (1) einfügen und einen ersten rechtwinklig umgebogenen Rand (22), der sich an die erste Abdeckung (3) anlehnt, dadurch gekennzeichnet, daß jede erste Zwischenwand (2) einen zweiten rechtwinklig umgebogenen Rand (23) hat, der gegen eine erste Abschirmleitung (10) auf der ersten Seite der Leiterplatte (1) gerichtet ist, derart, daß die Keile (24) jeder ersten Zwischenwand die Fortsetzung des zweiten Randes (23) bilden, wobei sie in bezug auf den zweiten Rand rechtwinklig umgebogen sind, um in die ersten metallisierten Löcher (132) der Leiterplatte hineinzuragen.

2. Abschirmstruktur nach Anspruch 1, dadurch gekennzeichnet, daß sich der erste und der zweite Rand (22, 23) gegenüberstehen.

3. Abschirmstruktur nach Anspruch 1 oder 2, dadurch gekennzeichnet, daß jede erste Zwischenwand (7) aus zwei getrennten Elementen (71, 72) gebildet ist, einem ersten Element (71), das den ersten Rand (712) und ein Wandstück (711) umfaßt, und einem zweiten Element (72), das den zweiten Rand (723), die Keile (724) und ein Wandstück (721) umfaßt, derart, daß die beiden Wandstücke durch Befestigungsmittel gegeneinander gehalten werden, wie durch Lötpunkte (63), die nach Befestigung der Keile (724) in den Löchern der Leiterplatte (1) und vor der Montage der ersten Abdeckung (3) auf den ersten Rändern (712) angebracht werden.

4. Abschirmstruktur nach Anspruch 3, dadurch gekennzeichnet, daß die Wandteile (711, 721) der beiden Elemente (71, 72) jeder ersten Zwischenwand (7) zusammenwirkende Zentrier- und Positioniermittel, wie Zentrierdorne (A) auf einem (71) der Elemente und entsprechende Positionieröffnungen (B) im anderen Element (72) aufweisen.

5. Abschirmstruktur nach einem der Ansprüche 1 bis 4, dadurch gekennzeichnet, daß sie eine zweite Abdeckung (5) unter der zweiten Seite der Leiterplatte (1) und zweite Zwischenwände (4, 6) zwischen der Leiterplatte und der zweiten Abdeckung aufweist, wobei jede zweite Zwischenwand genau unterhalb einer ersten Zwischenwand (2, 7) angeordnet ist und einen analoge Form wie die ersten Zwischenwände hat und dabei um 180° um eine Parallelachse zur Leiterplatte (1) gegenüber der zugeordneten ersten Zwischenwand gedreht ist, und dadurch gekennzeichnet, daß der zweite Rand (43, 623) jeder zweiten Zwischenwand (4, 6) gegen eine zweite Abschirmleitung (11) auf der zweiten Seite der Leiterplatte (1) und unterhalb der ersten Abschirmleitung (10) gelegt ist, gegen welche der zweite Rand (23, 723) der ersten zugeordneten Zwischenwand (2, 7) gelegt ist, wobei die Keile (24, 44; 624, 724) der entsprechenden ersten und zweiten zugeordneten Zwischenwände in metallisierte Löcher (132, 134) eintauchen und die beiden Abschirmleitungen (10, 11) miteinander verbinden.

6. Abschirmstruktur nach Anspruch 5, dadurch gekennzeichnet, daß die Ränder (22, 23, 42, 43; 712, 723, 623, 612) der einander zugeordneten ersten und zweiten Zwischenwände zwischen den Wandpartien (21, 41; 711, 721, 612, 621) dieser Zwischenwände übereinanderliegen.

7. Abschirmstruktur nach Anspruch 6, dadurch gekennzeichnet, daß die Keile (24, 44) jeder der einander zugeordneten ersten und zweiten Zwischenwände (2, 4) in Löcher (45, 25) des zweiten Randes (43, 23) der anderen Zwischenwand (4, 2) eintauchen.

8. Abschirmstruktur nach einem der Ansprüche 1 bis 7, dadurch gekennzeichnet, daß der erste Rand (22, 42, 712, 612) jeder Zwischenwand (2, 4, 7, 6) an der entsprechenden Abdeckung (3, 5) mit auswechselbaren Befestigungsmitteln (8) fixiert ist.

9. Abschirmstruktur nach Anspruch 8, dadurch gekennzeichnet, daß die Befestigungsmittel durch pinzettenartige Federn (8—82) gebildet sind, von denen jede zwei flexible Arme (821—822), die durch zwei Löcher ($E_3$, $E_2$, $E_7$, $E_5$, $E_4$, $E_6$) der Abdeckung (3, 5) und des ersten Randes der Zwischenwand (22, 712; 42, 612) hindurchragen, sowie ein Bodenstück (812), das gegen die Außenseite der Abdeckung (3, 5) anliegt, aufweist, und daß die flexiblen Arme (821—822) jeder pinzettenartigen Feder (8—82) Knicke haben (zwischen 811 und 821), die durch ihre Elastizität sauber gegen den Rand der Öffnungen ($E_2$, $E_7$; $E_4$, $E_6$) des ersten Randes der Zwischenwand (22, 712; 42, 612) anliegen.

10. Abschirmstruktur nach Anspruch 9, dadurch gekennzeichnet, daß die pinzettenartigen Federn (8—82) zur Befestigung einer Zwischenwand (2, 4, 7, 6) durch ein einstückiges Befestigungsband (8) gebildet sind, dessen Basis ein rechteckiges Band (81) ist, das gemeinsam die Bodenstücke (811—812) der pinzettenartigen Federn (8—82) bildet.

11. Abschirmstruktur nach Anspruch 9 oder 10, dadurch gekennzeichnet, daß das Bodenstück (812) jeder pinzettenartigen Feder (8—82) U-förmig ist und gegen die Abdeckung (3, 5) anliegende Schenkel (811) aufweist.

12. Abschirmstruktur nach einem der Ansprüche 1 bis 11, dadurch gekennzeichnet, daß die Keile (24, 44, 624, 724) der Zwischenwände (2, 4, 6, 7) in die metallisierten Löcher (132, 134) der Leiterplatte (1) eingelötet sind, vorzugsweise beim Durchgang durch ein Lötbad.

13. Abschirmstruktur nach einem der Ansprüche 1 bis 12, dadurch gekennzeichnet, daß die Abmessungen der Zwischenwände (2, 4, 6, 7), wie die Abstände zwischen den Keilen (24, 44, 624, 724) jeder Zwischenwand, und die Abmessungen der Ränder (22, 23, 42, 43, 612, 623, 712, 723) so gewählt sind, deß sie ganzzahlige Vielfache des Abstandes (p) von Leiterbahnen (14, 15) der Leiterplatte (1) bilden.

14. Werkzeug zur Demontage der pinzettenartigen Federn zur Befestigung einer Zwischenwand an einer Abdeckung gemäß Anspruch 11, dadurch gekennzeichnet, daß es spitz auslaufend gestaltet ist und im Längsschnitt (9) ein rechtwinkliges Dreieck bildet, dessen lange Kathete (91) zum Abstützen an der Außenseite der Abdeckkung (3, 5) und dessen Hypothenuse zum Gleiten (93) gegen die Bodenstücke (812) der pinzettenartigen Federn (8—82) bestimmt sind, um sie aus den übereinanderliegenden Löchern ($E_3$, $E_2$, $E_7$; $E_5$, $E_4$, $E_6$) der Abdeckung (3, 5) und des ersten Randes (22, 712; 42, 612) der Zwischenwand (2, 7; 4, 6) zu ziehen.

15. Werkzeug nach Anspruch 14, dadurch gekennzeichnet, daß es einen I-förmigen Querschnitt mit parallel zu der Hypothenuse (93) verlaufenden Flügeln (91, 92) aufweist.

**Claims.**

1. Shielding structure for printed circuit board comprising a first hood (3) above a first face of the board (1), and first partitions (2) between the board and the first hood, each first partition (2) comprising pins (24) insertable into first bores (132) of the board (1) and a first ledge (22) folded in a right-angle and applied against the first hood (3), characterized in that each first partition (2) comprises a second ledge (23) folded in a right-angle and applied against a first conducting shielding strip (10) on the first face of the board (1), and in that the pins (24) of each first partition extend the second ledge (23) and are folded in a right-angle with respect to the second ledge for coming into first metallized bores (132) of the board.

2. Shielding structure according to claim 1, characterized in that the first and second ledges (22, 23) are opposite one another.

3. Shielding structure according to claim 1 or 2, characterized in that each first partition (7) is maked up with two distinct elements (71, 72), a first member (71) including the first ledge (712) and a portion (711) forming a wall and a second member (72) including the second ledge (723), the pins (724) and a portion (721) forming a wall, and in that the forming-a-wall portions (711, 721) are held one against the other by fastening means, such as solder points (63), applied after the pins (724) have been fixed into the bores of the board (1) and before the first hood (3) have been assembled on the first ledges (712).

4. Shielding structure according to claim 3, characterized in that the forming-a-wall portions (711, 721) of the two members (71, 72) of each first partition (7) comprise centring and positioning means cooperating one with another, such as centring bosses (A) on one (71) of the two members and positioning recesses (B) in the other member (72).

5. Shielding structure according to any one of claims 1 to 4, characterized in that it comprises a second hood (5) below the second face of the board (1) and second partition (4; 6) between the printed board and the second hood, each second partition being respectively slightly below a first partition (2; 7), having an analogous shape to the first partitions and a position deducted from that of the first partition by turning it over at 180° around an axis parallel to the board (1), and in that the second ledge (43; 623) of each second partition (4; 6) is applied against a second conducting shielding strip (11) on the second face of the board (1) and subjacent to the first shielding strip (10) against which is applied the second ledge (23; 723) of the first associated partition (2; 7), the pins (24, 44; 624, 724) of the first and second associated partitions coming into metallized bores (132, 134) linking together the two shielding strips (10, 11).

6. Shielding structure according to claim 5, characterized in that the ledges (22, 23, 42, 43; 712, 723, 7623, 612) of the first and second associated partitions (2, 4; 7, 6) are superposed between the forming-a-wall portions (21, 41; 711, 721, 612, 621) of said associated partitions.

7. Shielding structure according to claim 6, characterized in that the pins (24, 44) of each first and second associated partitions (2, 4) come into bores (45, 25) of the second ledge (43, 23) of the other partition (4, 2).

8. Shielding structure according to any one of claims 1 to 7, characterized in that the first ledge (22, 42, 712, 612) of each partition (2, 4, 7, 6) are fastened to the corresponding hood (3, 5) by detachable fastening means (8).

9. Shielding structure according to claim 8, characterized in that the fastening means are made up of tweezers-springs (8—82) each having two flexible branches (821—822) going through two openings ($E_3$, $E_2$, $E_7$; $E_5$, $E_4$, $E_6$) of the hood (3; 5) and of the first partition ledge (22, 712; 42, 612), and a bottom (812) applied against the external face of the hood (3; 5), and in that the flexible branches (821—822) of each tweezer-spring (8—82) have bends (between 811 and 821) fitting by their own flexion against the edge of the opening ($E_2$, $E_7$; $E_4$, $E_6$) of first partition ledge (22, 712; 42, 612).

10. Shielding structure according to claim 9, characterized in that the tweezers-springs (8—82) for fastening a partition (2, 4, 7, 6) are formed as an integral fastening strip (8) whose bottom (812) is a rectangular strip (81) common to the bottoms (811—812) of the tweezers-springs (8—82).

11. Shielding structure according to claim 10 or 11, characterized in that the bottom (812) of each tweezer-spring (8—82) is U-shaped and has edges (811) applied against the hood (3, 5).

12. Shielding structure according to any one of claims 1 to 11, characterized in that the pins (22, 44, 624, 724) of the partitions (2, 4, 6, 7) are welded in the metallized bores (132, 134) of the board (1), preferably by tin wave welding.

13. Shielding structure according to any one of claims 1 to 12, characterized in that sizes of the partitions (2, 4, 6, 7) such as the distances between pins (24, 44, 624, 724) of each partition and the sizes of the ledges (22, 23, 42, 43, 612, 712, 723) are chosen as integer multiple numbers of the pitch (p) between conducting strips (14, 15) of the board (1).

14. Toal for removing the tweezers-springs intented for fastening a partition to a hood, according to claim 11, characterized in that it is formed as a point (9) having a longitudinal cross-section analogous to a right-angled triangle whose major side (91) is intended to be applied against the external face of the hood (3, 5) and whose hypotenuse (93) is intended to slide against the bottom (812) of the tweezers-springs (8—82) to remove them from the superposed openings ($E_3$, $E_2$, $E_7$; $E_5$, $E_4$, $E_6$) of the hood (3, 5) and of the first ledge (22, 712; 42, 612) of the partition (2, 7; 4, 6).

15. Toal according to claim 14, characterized in that its transverse cross-section is I-shaped with flanks (91, 92) parallel to the hypotenuse (93).

Fig_1_

Fig _ 2 _

Fig. 3

Fig. 4.

Fig.5a.

Fig.5b.

V

2 p

4 p

2 p

p

612

611

E6

A

Ligne pliage

61

Fig. 6.

Fig. 7a.

Fig. 7b.

Fig. 8.

Fig_9_

Fig. 10.

Fig_11_

Fig_12a_

Fig_12b_